# EUROPEAN PATENT SPECIFICATION

(11) **EP 2 377 683 B1**
(45) Date of publication and mention of the grant of the patent: **18.04.2018**
(21) Application number: 11250187.9
(22) Date of filing: 17.02.2011
(51) Int. Cl.: C22C 19/05, B32B 15/01, C23C 4/08, C23C 28/02, C23C 30/00, C23C 28/00, C30B 29/52

(54) **Metallic coating for single crystal alloys**
Metallischer Überzug für Einkristalllegierungen
Revêtement métallique pour alliages de cristal simple

(30) Priority: 16.04.2010 US 761667
(43) Date of publication of application: 19.10.2011
(73) Proprietor: United Technologies Corporation, Farmington, CT 06032 (US)
(72) Inventor: Bose, Sudhangshu, Manchester Connecticut 06040 (US); Maloney, Michael J., Marlborough Connecticut 06447 (US); Cetel, Alan D., West Hartford Connecticut 06117 (US); Seetharaman, Venkatarama, Rocky Hill Conecticut 06067 (US); Litton, David A., West Hartford Connecticut 06107 (US); Woodward, Shiela R., South Windsor Connecticut 06074 (US)
(74) Representative: Hall, Matthew Benjamin

(56) References cited:
- EP-A1- 0 194 391
- EP-A1- 0 532 150
- EP-A1- 1 036 850
- EP-A1- 1 674 658
- EP-A1- 1 876 263
- EP-A2- 1 837 412
- EP-A2- 2 014 784
- WO-A2-02/50323
- US-A- 5 523 170
- US-A- 5 783 318
- US-A1- 2003 044 634
- US-A1- 2004 096 690
- US-A1- 2006 219 329
- US-A1- 2006 219 330
- US-A1- 2010 008 816
- US-B1- 6 468 367
- US-B1- 6 565 680

## Description

The present disclosure is directed to advanced metallic coating compositions that are designed to provide environmental protection and improve the performance of single crystal superalloys having significant amounts of rhenium and/or ruthenium.

Advanced single crystal superalloys are currently being developed by engine manufacturers and research laboratories. These advanced single crystal superalloys contain significant amounts of rhenium and ruthenium, along with high levels of traditional refractory elements such as tantalum, molybdenum, and tungsten. Because of the presence of high levels of refractory metals, these alloys exhibit enhanced creep strength properties at high temperatures. Such strengthened alloys are coated with traditional metallic coatings, such as MCrAlY or aluminide coatings, which can act as a bond coat for subsequent deposition of thermal barrier coatings (TBCs) and to improve the oxidation resistance of the substrate at high temperatures.

An important concern with this class of single crystal alloys is their susceptibility to various microstructural instabilities. It has been observed that if traditional production oxidation resistant metallic coatings were applied to high rhenium and/or ruthenium containing single crystal alloys, deleterious phases precipitated in the single crystal alloy adjacent to the coating. The phase instability was determined to result from the diffusion of aluminum from the coating into the alloy substrate causing an increase in the volume fraction of gamma prime phase, leading to higher concentrations of refractory elements including rhenium into the gamma matrix. At critical concentration levels of the rhenium and other refractory elements in the gamma phase, the secondary reaction zone (SRZ) instability is nucleated. The degree of phase instability could consume enough of the component wall thickness to compromise the integrity of the airfoil. Presence of the SRZ instability could also compromise durability as its high angle boundary nature can result in early crack initiation.

During a typical coating operation, and in subsequent diffusion heat treatments at temperatures of 1900 degrees Fahrenheit (1037°C) and higher, the single crystal superalloy substrate can react with the coating and form a variety of precipitates at the substrate/bond coat interface. The precipitates form as a result of interdiffusion of the constituents between the substrate and the coating. As a result, a secondary reaction zone instability forms which contains clusters of gamma prime and topologically close packed (TCP) phases. The SRZ ties up some of the strengthening elements, thereby reducing the overall strength of the single crystal alloy. More importantly, the SRZ forms with a morphology of coarse, lamellar colonies between the primary diffusion zone and the single crystal structure and are bounded by high angle grain boundaries. As a result of the formation of SRZ, the mechanical properties of the single crystal alloy are significantly degraded.

There is needed a metallic coating which fully exploits the capabilities of superalloys containing high levels of rhenium and/or ruthenium.

There is also a needed a coating which reduces, eliminates, or delays the formation of SRZ and thereby avoids the degradation in mechanical properties.

US 5783318 A, US 2003/044634 A1, EP 1837412 A2, US 2010/008816 A1, EP 1674658 A1, US 2006/219330 A1, US 2006/219329 A1, US 6565680 B1, EP 1876263 A1, US 6468367 B1, WO 02/50323 A2, EP 1036850 A1, US 2004/096690 A1, US 5523170 A, EP 0532150 A1, EP 0194391 A1 and EP 2014784 A2 disclose nickel based superalloy compositions.

The present invention provides a process for forming an article for use in a high temperature application comprises providing a substrate formed from a single crystal nickel based alloy containing at least one of from 2.0 to 6.0 wt% rhenium and from 2.0 to 6.0 wt% ruthenium and depositing a metallic coating on a surface of said substrate, said metallic coating depositing step comprises depositing a nickel base alloy consisting of from 5.0 to 10.5 wt% aluminum, from 4.0 to 15 wt% chromium, from 2.0 to 8.0 wt% tungsten, from 3.0 to 10 wt% tantalum, from 1.0 to 5.0 wt% ruthenium and the being balance nickel with unavoidable impurities, wherein the nickel base alloy optionally further contains up to 5.0 wt% rhenium, up to 0.4 wt% molybdenum, from 0.1 to 0.5 wt% hafnium, from 0.05 to 0.5 wt% yttrium, from 5 to 20 wt% cobalt, up to 0.2 wt% manganese, up to 0.2 wt% silicon, up to 0.03 wt% phosphorous, up to 0.03 wt% sulfur, up to 0.1 wt% carbon, up to 0.01 wt% boron, up to 0.5 wt% iron, up to 0.3 wt% copper, up to 0.1 wt% zirconium, and up to 0.01 wt% each of lead, bismuth, selenium, tellurium, and thallium.

In another aspect, the present invention provides a metallic coating for use in a high temperature application comprises a nickel base alloy consisting of from 5.0 to 10.5 wt% aluminum, from 4.0 to 15 wt% chromium, from 2.0 to 8.0 wt% tungsten, from 3.0 to 10 wt% tantalum, from 1.0 to 5.0 wt% ruthenium and the being balance nickel with unavoidable impurities, wherein said nickel base alloy optionally further contains at least one additional constituent selected from the group consisting of up to 5.0 wt% rhenium, up to 0.4 wt% molybdenum, from 0.1 to 0.5 wt% hafnium, from 0.05 to 0.5 wt% yttrium, from 5 to 20 wt% cobalt, up to 0.2 wt% manganese, up to 0.2 wt% silicon, up to 0.03 wt% phosphorous, up to 0.03 wt% sulfur, up to 0.1 wt% carbon, up to 0.01 wt% boron, up to 0.5 wt% iron, up to 0.3 wt% copper, up to 0.1 wt% zirconium, and up to 0.01 wt% each of lead, bismuth, selenium, tellurium, and thallium.

In yet another aspect, the present invention provides an article for use in a high temperature application comprises a substrate formed from a single crystal nickel based alloy containing at least one of from 2.0 to 6.0 wt% rhenium and from 2.0 to 6.0 wt% ruthenium and a metallic coating deposited on said substrate, wherein the metallic coating is a metallic coating as described above.
Fig. 1 is a photomicrograph showing a MCrAlY (not within the scope of the invention) after 600 hours isothermal exposure at 1800 degrees Fahrenheit (982°C) in an air furnace; and
Fig. 2 is a photomicrograph showing a coating with a lower aluminum activity after 600 hours exposure in air at 1800 degrees Fahrenheit (982°C).

The present disclosure utilizes a coating, in conjunction with single crystal superalloys containing from 2.0 to 6.0 wt% rhenium and/or from 2.0 to 6.0 wt% ruthenium, that has a lower level of aluminum as compared to conventional oxidation resistant MCrAlY type coatings. The single crystal alloy which is used for the substrate should have a relatively low level of aluminum and has adequate oxidation resistance to survive in a high temperature and pressure environment, such as in the high pressure turbine section of a turbine engine.

The metallic coating described herein may be used as a stand-alone coating or as a bond coat. The metallic coating is formed from a nickel base alloy according to claim 2 containing from 5.0 to 10.5 wt% aluminum, from 4.0 to 15 wt% chromium, from 2.0 to 8.0 wt% tungsten, from 3.0 to 10 wt% tantalum, from 1.0 to 5.0 wt% ruthenium and the balance nickel with unavoidable impurities. The nickel base alloy may further contain at least one additional constituent selected from the group consisting of up to 5.0 wt% rhenium, up to 0.4 wt% molybdenum, from 0.1 to 0.5 wt% hafnium, and from 0.05 to 0.5 wt% yttrium. The nickel base alloy may further contain from 5.0 to 20 wt% cobalt. Additional elements which may be added to the nickel base alloy include up to 0.2 wt% manganese, up to 0.2 wt% silicon, up to 0.03 wt% phosphorous, up to 0.03 wt% sulfur, up to 0.1 carbon, up to 0.1 wt% yttrium, up to 0.01 wt% boron, up to 0.5 wt% iron, up to 0.3 wt% copper, up to 0.1 wt% zirconium, and up to 0.01 wt% each of lead, bismuth, selenium, tellurium, and thallium. The compositional ranges set forth herein allow one to optimize the oxidation resistance and SRZ susceptibility of the bond coat.

The metallic coating may be applied to a single crystal alloy substrate using any suitable technique known in the art, such as low pressure plasma spray or cathodic arc deposition techniques. Cathodic arc may be used to form thinner coatings which are useful for high pressure turbine airfoils that are life-limited by thermomechanical fatigue. Vacuum or low pressure plasma spray may be used to form thicker coatings, which are useful for turbine airfoils that are life-limited by oxidation.

The metallic coating may be applied in a single layer or as multiple layers. Each layer may have a thickness in the range of from 0.0003 inches (0.0076 mm) to 0.015 inches (0.381 mm). The metallic coatings described herein may have a coefficient of thermal expansion which is a close match to the coefficient of thermal expansion of the base alloy from room temperature to 2200 degrees Fahrenheit (1204°C). The metallic coatings may also have very low porosity, even lower surface-connected porosity, sufficient ductility to be able to reduce surface roughness by finishing processes such as peening, attrition, grit blasting and/or media polishing techniques without cracking, and/or minimal beta (NiAl solid solution) phase content to avoid volume changes on phase transformation due to aluminum depletion. The chemistry for the metallic coating may be engineered to ensure minimal chemical gradients between the metallic coating and the base alloy, while still ensuring the rapid formation of an essential pure alpha alumina protective alumina layer, and retention of the adherence of the protective alumina layer over long high temperature exposures and many thermal cycles.

If desired, the metallic coating may be a bondcoat which is the first layer of a multi-layer bond coat system.

The metallic coating of the present invention is particularly useful for providing improved oxidation resistance and SRZ susceptibility to substrates formed from single crystal alloys having at least one of from 2.0 to 6.0 wt% rhenium and from 2.0 to 6.0 wt% ruthenium. The metallic coating provides oxidation resistance and SRZ susceptibility by reducing the aluminum content, relative to other bondcoats. As a result, the chemical gradient or chemical potential from the bondcoat to the alloy is reduced, resulting in a reduced driving force for diffusion. Furthermore, the addition of ruthenium, cobalt, molybdenum, tungsten, and rhenium to the metallic coating reduces diffusion of all species in the alloy. This is because the relatively high atomic weight of these elements reduces their vibratory amplitudes at a given temperature relative to lighter elements. On average, over the whole crystal lattice, there is less distortion at a given temperature, thus less local disorder. Local disorder is required for diffusion to occur. Less local disorder on average results in less diffusion on average. SRZ formation is dependent on the transformation of gamma grains to gamma-prime grains. Since several of the refractory elements (such as rhenium) have relatively high solubility in gamma grains, but almost no solubility in gamma-prime grains, transformation from gamma to gamma prime results in expulsion of refractory elements, leading to buildup of the refractory elements in the high angle grain boundaries until the local content is high enough to form new phases, such as P phase containing high Re and other refractory element content, which is topologically close-packed, and forms high-angle grain boundaries with gamma and gamma prime. As previously discussed, these are deleterious. The key is to avoid gamma to gamma prime phase transformations. These can happen by aluminum diffusion from the coating to the alloy, increasing the Ni:Al ratio in the alloy, which results in gamma transformation to gamma prime. Alternatively, diffusion of nickel from the alloy to the bondcoat increases the Ni:Al ratio. State of art bondcoats have more aluminum and less nickel than the alloy substrates that they are deposited on, so there is a driving force for Ni to diffuse up into the bondcoat, and for Al diffusion down into the alloy - leading to gamma prime formation in the alloy, then SRZ formation. Therefore, slowing down diffusion in general is a good thing, as is reducing the chemical gradients between bondcoats and alloys, to reduce the driving force for diffusion. The metallic coating described herein is designed to do that.

One type of material which can be used for the substrate is a single crystal nickel based alloy having a composition which contains from 1.5 to 2.5 wt% chromium, from 15 to 17 wt% cobalt; from 0.5 to 1.5 wt% molybdenum, from 5.0 to 6.5 wt% tungsten, from 5.5 to 6.0 wt% rhenium, from 7.0 to 9.5 wt% tantalum, and from 0.1 to 0.5 wt% hafnium. Another material suitable for the substrate is a single crystal nickel based alloy having a composition which contains from 4.5 to 5.5 wt% chromium, from 9.0 to 11 wt% cobalt, from 1.5 to 2.5 wt% molybdenum, from 5.0 to 6.5 wt% tungsten, from 2.5 to 3.5 wt% rhenium, from 7.0 to 9.5 wt% tantalum, and from 0.1 to 0.5 wt% hafnium. Other suitable substrate materials include PWA 1487, MX-4, Rene N6, CMSX-10, CMSX-10M, TMS-75, TMS-138 and TMS-162.

The metallic coating may be heat treated at a temperature above 1900 degrees Fahrenheit (1037°C) for 4 hours in a vacuum to improve the bonding between the bond coat and the base alloy (substrate).

LPPS (low pressure plasma spray) bondcoats can be peened via gravity assisted shot peening (GASP). This is typically done at room temperature for 60 minutes. Alternative peening methods for LPPS bondcoats include cut wire peening.

For cathodic arc bond coats, since they are much denser in the as-deposited condition than LPPS bond coats, ceramic pressure peening is used. In this case, zirconia-based spherical media, mesh size 8 to 46, is blasted onto the coating using a nozzle with a pressure of 20 to 40 psi (138 to 276 kPa), typically for 3 to 10 minutes.

Peening may not be carried out for air plasma spray ceramic thermal barrier topcoats, since the surface roughness is needed for mechanical bonding of the thermal barrier coating.

For vapor deposited ceramic thermal barrier topcoats, the bond coat is baked at a temperature ranging from 400 to 800 degrees Fahrenheit (204 to 427°C) for a few tens of minutes in air, to burn off any hydrocarbons that might be present from previous processing. Then, a grit blast using air pressure of 10 to 60 psi (69 to 414 kPa)(30 - 50 nominal) and grit size between 300-grit and 180-grit, typically alumina, is carried out, just before coating the parts. Optionally, ultrasonic cleaning in water for roughly 5 minutes followed by drying at 200 degrees Fahrenheit (93°C) in air is carried out immediately before depositing the TBC coating.

When the metallic coating of described herein is used as a bondcoat, any suitable thermal barrier coating may be deposited. For example, a 7 wt% yttria stabilized thermal barrier coating may be deposited. Also thermal barrier coatings containing oxides of any of the metals of the lanthanide series of the periodic table (La through Lu) or Y, or Sc, or In in amounts ranging from 2 mole% to 50 mole%, or any mixtures thereof, with a preferred range of from 4 mole% to 40 mole%.

The metallic coating described herein has numerous advantages including (1) decreased driving force for SRZ formation relative to all current state-of-the-art bondcoats, due to lower concentration gradients, primarily for Ni and Al, but also for the refractory elements; (2) reduced interdiffusion of all bondcoat and alloy species, which retards SRZ formation and growth; (3) higher bond coat strength than state-of-the art MCrAlYs, with no significant reduction in ductility; (4) better ductility in comparison to aluminides and Pt-aluminides; and (5) little to no beta phase in contrast to MCrAlYs, aluminides, and Pt-aluminides. The fact that there is little to no beta phase is significant in that beta phase (nominally NiAl) undergoes a diffusionless martensitic phase transformation during thermal cycling and can contribute to strain buildup in the system. Also, when beta gets depleted of Al, it transforms to gamma or gamma prime, with a volume change that also contributes to strain buildup in the system. These strain buildups are known contributors to spallation of the TGO (thermally grown oxide) and/or the TBC. Another advantage to the metallic coatings described herein is that they do not contain Pt, which gives them a cost advantage over Pt-aluminides.

### REFERENCE

### EXAMPLES

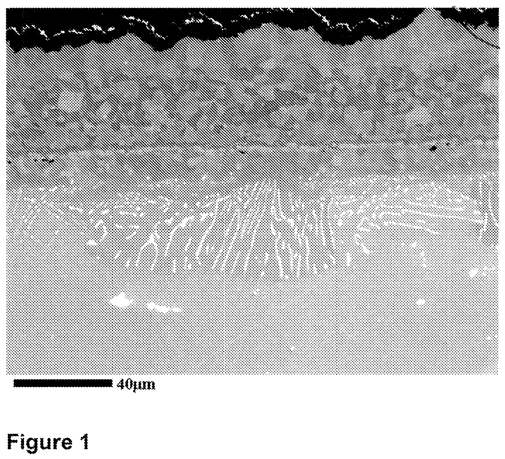

Fig. 1 shows a MCrAlY bondcoat after 600 hours isothermal exposure at 1800 degrees Fahrenheit (982°C) in an air furnace. As can be seen from this figure, there is a coating layer, an interdiffusion zone, and a secondary reaction zone extending into the base alloy. The secondary reaction zone consists of bright white, curvilinear phases in a darker contrast matrix phase. The elongated bright white phases are detrimental "P" phases, which consists of compounds such as ReNi (rhenium nickel). Other refractory elements, such as W, Mo, and Ta are likely in solid solution to some extent in the P phases as well. The P phases are detrimental because they form high angle grain boundaries with the matrix phase(s), which are weak, relative to the base alloy. These grain boundaries are likely to act as crack initiation sites, reducing the strength of the system.

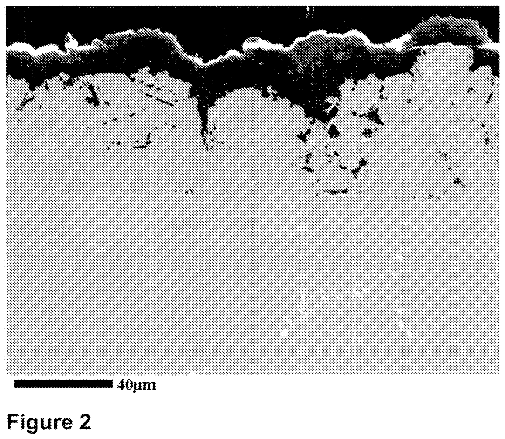

Fig. 2 shows a coating with a lower aluminum activity than current MCrAlYs, also after 600 hours exposure in air at 1800 degrees Fahrenheit (982°C). No secondary reaction zone is evident under the coating. There are recrystallized colonies evident under the coating - the somewhat elongated oval-shaped dark contrast phases - but they do not contain any P-phases. These colonies are much less detrimental than SRZs, since there are no high angle grain boundaries on which to initiate cracks. The coating in Fig. 2 had a composition in wt% of 61.41% Ni, 7.23% Al, 11.90% Co, 9.33% Cr, 0.13% Hf, 0.16% Si, 0.48% Y, 1.23% Mo, 1.3% Re, 4.35% Ta, and 2.5% W.

Cyclic oxidation burner rig testing of the lower Al activity coating showed that it had 56% the life of MCrAlY coatings. In this case, both coatings were on a single crystal superalloy substrate. Although the low Al activity coating showed an oxidation debit in the test, the coating process for that coating composition had not been optimized.

It is apparent that there has been provided a metallic coating for single crystal alloys. While the metallic coating has been described in the context of specific embodiments thereof, other unforeseeable alternatives, modifications, and variations may become apparent to those skilled in the art having read the foregoing description. Accordingly, it is intended to embrace those alternatives, modifications, and variations which fall within the broad scope of the appended claims.

## Claims

1. A process for forming an article for use in a high temperature application comprises providing a substrate formed from a single crystal nickel based alloy containing at least one of from 2.0 to 6.0 wt% rhenium and from 2.0 to 6.0 wt% ruthenium and depositing a metallic coating on a surface of said substrate, said metallic coating depositing step comprises depositing a nickel base alloy consisting of from 5.0 to 10.5 wt% aluminum, from 4.0 to 15 wt% chromium, from 2.0 to 8.0 wt% tungsten, from 3.0 to 10 wt% tantalum, from 1.0 to 5.0 wt% ruthenium and the being balance nickel with unavoidable impurities, wherein the nickel base alloy optionally further contains up to 5.0 wt% rhenium, up to 0.4 wt% molybdenum, from 0.1 to 0.5 wt% hafnium, from 0.05 to 0.5 wt% yttrium, from 5 to 20 wt% cobalt, up to 0.2 wt% manganese, up to 0.2 wt% silicon, up to 0.03 wt% phosphorous, up to 0.03 wt% sulfur, up to 0.1 wt% carbon, up to 0.01 wt% boron, up to 0.5 wt% iron, up to 0.3 wt% copper, up to 0.1 wt% zirconium, and up to 0.01 wt% each of lead, bismuth, selenium, tellurium, and thallium.

2. A metallic coating for use in a high temperature application comprises a nickel base alloy consisting of from 5.0 to 10.5 wt% aluminum, from 4.0 to 15 wt% chromium, from 2.0 to 8.0 wt% tungsten, from 3.0 to 10 wt% tantalum, from 1.0 to 5.0 wt% ruthenium and the being balance nickel with unavoidable impurities, wherein said nickel base alloy optionally further contains at least one additional constituent selected from the group consisting of up to 5.0 wt% rhenium, up to 0.4 wt% molybdenum, from 0.1 to 0.5 wt% hafnium, from 0.05 to 0.5 wt% yttrium, from 5 to 20 wt% cobalt, up to 0.2 wt% manganese, up to 0.2 wt% silicon, up to 0.03 wt% phosphorous, up to 0.03 wt% sulfur, up to 0.1 wt% carbon, up to 0.01 wt% boron, up to 0.5 wt% iron, up to 0.3 wt% copper, up to 0.1 wt% zirconium, and up to 0.01 wt% each of lead, bismuth, selenium, tellurium, and thallium.

3. The metallic coating according to claim 2, wherein said nickel base alloy further contains up to 5.0 wt% rhenium, up to 0.4 wt% molybdenum, from 0.1 to 0.5 wt% hafnium, and from 0.05 to 0.5 wt% yttrium.

4. The metallic coating according to claim 2 or 3, wherein said coating is a bondcoat.

5. The metallic coating according to claim 2 or 3, wherein said coating is a standalone coating providing oxidation and/or corrosion resistance.

6. An article for use in a high temperature application comprises a substrate formed from a single crystal nickel based alloy containing at least one of from 2.0 to 6.0 wt% rhenium and from 2.0 to 6.0 wt% ruthenium and a metallic coating deposited on said substrate, wherein the metallic coating is a metallic coating according to any one of claims 2 to 5.

7. The article according to claim 6, wherein said single crystal nickel based alloy contains from 4.5 to 5.5 wt% chromium, from 9.0 to 11 wt% cobalt; from 1.5 to 2.5 wt% molybdenum, from 5.0 to 6.5 wt% tungsten, from 2.5 to 3.5 wt% rhenium, from 7.0 to 9.5 wt% tantalum, and from 0.1 to 0.5 wt% hafnium.

## Patentansprüche

1. Verfahren zum Formen eines Teils zur Verwendung in einer Hochtemperaturanwendung, umfassend das Bereitstellen eines Substrats, das aus einer Einkristalllegierung auf Nickelbasis gebildet ist, die mindestens entweder von 2,0 bis 6,0 Gew.-% Rhenium oder von 2,0 bis 6,0 Gew.-% Ruthenium enthält, und das Aufbringen eines metallischen Überzugs auf eine Oberfläche dieses Substrats, wobei der Schritt des Aufbringens des metallischen Überzugs das Aufbringen einer Legierung auf Nickelbasis umfasst, die aus von 5,0 bis 10,5 Gew.-% Aluminium, von 4,0 bis 15 Gew.-% Chrom, von 2,0 bis 8,0 Gew.-% Wolfram, von 3,0 bis 10 Gew.-% Tantal, von 1,0 bis 5,0 Gew.-% Ruthenium und aus dem Rest Nickel mit unvermeidbaren Unreinheiten besteht, wobei die Legierung auf Nickelbasis optional weiter bis zu 5,0 Gew.-% Rhenium, bis zu 0,4 Gew.-% Molybdän, von 0,1 bis 0,5 Gew.-% Hafnium, von 0,05 bis 0,5 Gew.-% Yttrium, von 5 bis 20 Gew.-% Kobalt, bis zu 0,2 Gew.-% Mangan, bis zu 0,2 Gew.-% Silizium, bis zu 0,03 Gew.-% Phosphor, bis zu 0,03 Gew.-% Schwefel, bis zu 0,1 Gew.-% Kohlenstoff, bis zu 0,01 Gew.-% Bor, bis zu 0,5 Gew.-% Eisen, bis zu 0,3 Gew.-% Kupfer, bis zu 0,1 Gew.-% Zirconium und jeweils bis zu 0,01 Gew.-% Blei, Bismut, Selen, Tellur und Thallium enthält.

2. Metallischer Überzug zur Verwendung in einer Hochtemperaturanwendung, umfassend eine Legierung auf Nickelbasis, die aus von 5,0 bis 10,5 Gew.-% Aluminium, von 4,0 bis 15 Gew.-% Chrom, von 2,0 bis 8,0 Gew.-% Wolfram, von 3,0 bis 10 Gew.-% Tantal, von 1,0 bis 5,0 Gew.-% Ruthenium und aus dem Rest Nickel mit unvermeidbaren Unreinheiten besteht, wobei die Legierung auf Nickelbasis optional weiter mindestens einen zusätzlichen Bestandteil enthält, der aus der Gruppe ausgewählt ist, die aus bis zu 5,0 Gew.-% Rhenium, bis zu 0,4 Gew.-% Molybdän, von 0,1 bis 0,5 Gew.-% Hafnium, von 0,05 bis 0,5 Gew.-% Yttrium, von 5 bis 20 Gew.-% Kobalt, bis zu 0,2 Gew.-% Mangan, bis zu 0,2 Gew.-% Silizium, bis zu 0,03 Gew.-% Phosphor, bis zu 0,03 Gew.-% Schwefel, bis zu 0,1 Gew.-% Kohlenstoff, bis zu 0,01 Gew.-% Bor, bis zu 0,5 Gew.-% Eisen, bis zu 0,3 Gew.-% Kupfer, bis zu 0,1 Gew.-% Zirconium und jeweils bis zu 0,01 Gew.-% Blei, Bismut, Selen, Tellur und Thallium besteht.

3. Metallischer Überzug nach Anspruch 2, wobei die Legierung auf Nickelbasis weiter bis zu 5,0 Gew.-% Rhenium, bis zu 0,4 Gew.-% Molybdän, von 0,1 bis 0,5 Gew.-% Hafnium und von 0,05 bis 0,5 Gew.-% Yttrium enthält.

4. Metallischer Überzug nach Anspruch 2 oder 3, wobei der Überzug ein Haftvermittler ist.

5. Metallischer Überzug nach Anspruch 2 oder 3, wobei der Überzug eine eigenständige Beschichtung ist, die Beständigkeit gegenüber Oxidation und/oder Korrosion bietet.

6. Teil zur Verwendung in einer Hochtemperaturanwendung, umfassend ein Substrat, das aus einer Einkristalllegierung auf Nickelbasis gebildet ist, die mindestens entweder von 2,0 bis 6,0 Gew.-% Rhenium oder von 2,0 bis 6,0 Gew.-% Ruthenium enthält, und einen metallischen Überzug, der auf dieses Substrat aufgebracht ist, wobei der metallische Überzug ein metallischer Überzug nach einem der Ansprüche 2 bis 5 ist.

7. Teil nach Anspruch 6, wobei die Einkristalllegierung auf Nickelbasis von 4,5 bis 5,5 Gew.-% Chrom, von 9,0 bis 11 Gew.-% Kobalt; von 1,5 bis 2,5 Gew.-% Molybdän, von 5,0 bis 6,5 Gew.-% Wolfram, von 2,5 bis 3,5 Gew.-% Rhenium, von 7,0 bis 9,5 Gew.-% Tantal und von 0,1 bis 0,5 Gew.-% Hafnium enthält.

## Revendications

1. Procédé de formation d'un article pour son utilisation dans une application à température élevée comprenant la fourniture d'un substrat formé à partir d'un alliage à base de nickel monocristallin contenant au moins l'un de 2,0 à 6,0 % en poids de rhénium et de 2,0 à 6,0 % en poids de ruthénium et le dépôt d'un revêtement métallique sur une surface dudit substrat, ladite étape de dépôt de revêtement métallique comprend le dépôt d'un alliage à base de nickel constitué de 5,0 à 10,5 % en poids d'aluminium, de 4,0 à 15 % en poids de chrome, de 2,0 à 8,0 % en poids de tungstène, de 3,0 à 10 % en poids de tantale, de 1,0 à 5,0 % en poids de ruthénium et le reste étant du nickel avec les impuretés inévitables, dans lequel l'alliage à base de nickel contient en outre facultativement jusqu'à 5,0 % en poids de rhénium, jusqu'à 0,4 % en poids de molybdène, de 0,1 à 0,5 % en poids d'hafnium, de 0,05 à 0,5 % en poids d'yttrium, de 5 à 20 % en poids de cobalt, jusqu'à 0,2 % en poids de manganèse, jusqu'à 0,2 % en poids de silicium, jusqu'à 0,03 % en poids de phosphore, jusqu'à 0,03 % en poids de soufre, jusqu'à 0,1 % en poids de carbone, jusqu'à 0,01 % en poids de bore, jusqu'à 0,5 % en poids de fer, jusqu'à 0,3 % en poids de cuivre, jusqu'à 0,1 % en poids de zirconium, et jusqu'à 0,01 % en poids de chacun du plomb, du bismuth, du sélénium, du tellurium, et du thallium.

2. Revêtement métallique pour son utilisation dans une application à température élevée comprenant un alliage à base de nickel constitué de 5,0 à 10,5 % en poids d'aluminium, de 4,0 à 15 % en poids de chrome, de 2,0 à 8,0 % en poids de tungstène, de 3,0 à 10 % en poids de tantale, de 1,0 à 5,0 % en poids de ruthénium et le reste étant du nickel avec les impuretés inévitables, dans lequel ledit alliage à base de nickel contient facultativement en outre au moins un constituant supplémentaire sélectionné dans le groupe constitué de jusqu'à 5,0 % en poids de rhénium, de jusqu'à 0,4 % en poids de molybdène, de 0,1 à 0,5 % en poids d'hafnium, de 0,05 à 0,5 % en poids d'yttrium, de 5 à 20 % en poids de cobalt, de jusqu'à 0,2 % en poids de manganèse, de jusqu'à 0,2 % en poids de silicium, de jusqu'à 0,03 % en poids de phosphore, de jusqu'à 0,03 % en poids de soufre, de jusqu'à 0,1 % en poids de carbone, de jusqu'à 0,01 % en poids de bore, de jusqu'à 0,5 % en poids de fer, de jusqu'à 0,3 % en poids de cuivre, de jusqu'à 0,1 % en poids de zirconium, et de jusqu'à 0,01 % en poids de chacun du plomb, du bismuth, du sélénium, du tellurium, et du thallium.

3. Revêtement métallique selon la revendication 2, dans lequel ledit alliage à base de nickel contient en outre jusqu'à 5,0 % en poids de rhénium, jusqu'à 0,4 % en poids de molybdène, de 0,1 à 0,5 % en poids d'hafnium, et de 0,05 à 0,5 % en poids d'yttrium.

4. Revêtement métallique selon la revendication 2 ou 3, dans lequel ledit revêtement est une couche de liaison.

5. Revêtement métallique selon la revendication 2 ou 3, dans lequel ledit revêtement est un revêtement autonome fournissant une résistance à l'oxydation et/ou à la corrosion.

6. Article pour son utilisation dans une application à température élevée comprenant un substrat formé à partir d'un alliage à base de nickel monocristallin contenant au moins l'un de 2,0 à 6,0 % en poids de rhénium et de 2,0 à 6,0 % en poids de ruthénium et un revêtement métallique déposé sur ledit substrat, dans lequel le revêtement métallique est un revêtement métallique selon l'une quelconque des revendications 2 à 5.

7. Article selon la revendication 6, dans lequel ledit alliage à base de nickel monocristallin contient de 4,5 à 5,5 % en poids de chrome, de 9,0 à 11 % en poids de cobalt, de 1,5 à 2,5 % en poids de molybdène, de 5,0 à 6,5 % en poids de tungstène, de 2,5 à 3,5 % en poids de rhénium, de 7,0 à 9,5 % en poids de tantale, et de 0,1 à 0,5 % en poids d'hafnium.
